# FASCICULE DE BREVET EUROPEEN

(11) **EP 3 005 846 B1**
(45) Date de publication et mention de la délivrance du brevet: **13.12.2023**
(21) Numéro de dépôt: 14726394.1
(22) Date de dépôt: 27.05.2014
(51) Int. Cl.: H05K 1/11, H01L 23/00, H01L 23/498, G06K 19/077, H05K 3/00, H05K 3/46

(54) **PROCÉDÉ DE FABRICATION D'UN CIRCUIT IMPRIMÉ**
VERFAHREN ZUR HERSTELLUNG EINER BESTÜCKTEN SCHALTUNG
METHOD FOR PRODUCING A PRINTED CIRCUIT

(30) Priorité: 30.05.2013 FR 1354965
(43) Date de publication de la demande: 13.04.2016
(73) Titulaire: Linxens Holding, 78200 Mantes-la-Jolie (FR)
(72) Inventeur: DIEU-GOMONT, Séverine, F-78270 Limetz-Villez (FR); HOVEMAN, Bertrand, F-95610 Eragny-sur-Oise (FR)
(74) Mandataire: Regi, François-Xavier
(86) Numéro de dépôt international: PCT/EP2014/060989
(87) Numéro de publication internationale: WO 2014/191428

(56) Documents cités:
- FR-A1- 2 765 010
- US-A- 6 117 706
- US-A1- 2012 248 201
- US-B1- 6 288 904
- US-B1- 6 310 778

## Description

L'invention concerne le domaine des circuits imprimés. De tels circuits imprimés peuvent être utilisés par exemple pour réaliser des modules électroniques pour carte à puce, des antennes RFID, des diodes électroluminescentes.

L'invention est telle que décrite dans la revendication 1.

Les cartes à puce sont bien connues du public, qui en a de multiples usages : cartes de crédit, cartes SIM pour téléphones portable, cartes de transport, cartes d'identité, etc.

Les cartes à puce sont généralement constituées d'un support rigide en matière plastique de type PVC, PVC/ABS ou polycarbonate constituant l'essentiel de la carte, dans lequel est incorporé un module électronique fabriqué séparément. Ce module électronique comporte un circuit imprimé généralement flexible muni d'une puce électronique (circuit intégré) et de moyens de transmission pour transmettre des données de la puce à un dispositif lecteur de carte (lecture) ou de ce dispositif à la carte (écriture). Ces moyens de transmission de données peuvent être « à contact », « sans contact » ou bien « dual » lorsqu'ils combinent les deux précédents moyens.

Dans une carte à puce « à contact », un connecteur comporte des plages de contacts électriquement connectés à la puce et affleurant sur le module électronique, en surface du support, pour une connexion par contact électrique avec un dispositif lecteur de carte. Dans une carte à puce « sans contact », les données sont transmises à la puce grâce à un système radiofréquence fonctionnant entre une antenne se trouvant dans le lecteur et une antenne se trouvant dans la carte. Dans une carte à puce « dual », les moyens de transmission sont à la fois « à contact » et « sans contact », le module électronique comportant un circuit flexible muni d'une unique puce électronique capable de gérer les deux modes de transmissions de données.

Dans la suite de ce document, nous nous intéressons plus particulièrement aux circuits imprimés comportant plusieurs couches de matériau électriquement conducteur isolées les unes des autres par une couche de matériau isolant. Plus particulièrement encore, nous nous intéresserons à de tels circuits imprimés dans lesquels des trous de connexion (aussi appelés « via holes » selon la terminologie anglo-saxonne) sont réalisés dans la couche de matériau isolant. Ces circuits sont par exemple des circuits double-face ou multicouches dans lesquels des motifs, telles que des pistes conductrices, des contacts électriques, une antenne, ou des combinaisons de ces différents motifs, sont gravés dans au moins l'une des couches.

L'un des intérêts d'un trou de connexion est de permettre notamment le passage d'un fil conducteur à travers la couche de matériau isolant. En effet, l'une des couches de matériau électriquement conducteur peut être utilisée pour connecter une puce ou une diode à un plot de contact qui se trouve sur une face du circuit imprimé opposée à celle sur laquelle se trouve la puce. Soit le fil conducteur est connecté (par exemple par soudure - « wire-bonding » selon la terminologie anglo-saxonne) à une piste ou un plot d'une couche de matériau électriquement conducteur qui se trouve en périphérie d'un trou de connexion. Soit le fil conducteur est connecté directement sur une partie d'une couche de matériau électriquement conducteur qui obture au moins partiellement le trou de connexion. Dans ce cas, la surface de cette couche se trouvant face au trou de connexion peut être utilisée pour y connecter l'une des extrémités du fil, tandis que l'autre extrémité est connectée à un composant électronique tel qu'une puce (comme décrit, par exemple, dans le document US 6 288904 B1) ou une diode.

Un problème rencontré avec les circuits de l'art antérieur est que la réalisation de motifs dans une couche de matériau conducteur autre que celle obturant les trous de connexion conduit à la formation d'anneaux de matériau électriquement conducteur autour des trous de connexion. En effet, la réalisation de motifs dans une couche de matériau conducteur autre que celle obturant les trous de connexion nécessite une étape de gravure. En conséquence, les trous de connexion doivent être obturés pendant l'étape de gravure afin de protéger la couche de matériau électriquement conducteur obturant (au moins partiellement) les trous. Pour garantir que le liquide de gravure ne pénétrera pas dans les trous de connexion, un anneau de résine photosensible de quelques 50 à 250 micromètres est conservé autour de chaque trou de connexion. Sous ces anneaux, la couche de matériau électriquement conducteur ne sera pas retirée et des anneaux de matériau électriquement conducteur demeureront donc autour des trous de connexion. De tels anneaux peuvent devenir problématiques si un contact électrique est établi entre l'un d'entre eux et un fil de connexion.

Un but de l'invention est de palier au moins partiellement ce problème.

A cette fin, il est proposé selon l'invention un procédé de fabrication d'un circuit imprimé comprenant la réalisation d'un complexe comprenant une première et une deuxième couches de matériau électriquement conducteur solidaires d'un substrat isolant. Ces couches de matériau électriquement conducteur recouvrent les deux surfaces principales d'un substrat isolant pour former un circuit imprimé double face. Dans un aspect illustratif ne faisant pas partie de l'invention, elles peuvent également constituer deux des couches d'un circuit imprimé multicouches (avec plus de deux couches de matériau électriquement conducteur). Dans ce cas, elles peuvent être dans un complexe intermédiaire (avec deux couches de matériau électriquement conducteur isolées l'une de l'autre par un substrat isolant) sur lequel une ou plusieurs autres couches isolantes ou conductrices seront empilées ou sous la forme d'un complexe comportant déjà plus de deux couches de matériau électriquement conducteur. Dans le procédé selon l'invention, l'ordre des étapes de réalisation des première et deuxième couches de matériau électriquement conducteur n'est pas toujours pertinent. Dans certains cas, la première couche de matériau électriquement conducteur peut être réalisée avant ou après la deuxième couche de matériau électriquement conducteur. Dans certains cas encore, des étapes du procédé selon l'invention peuvent être intercalées entre celles de réalisation des premières et deuxième couches de matériau conducteur. Les termes « première » ou « deuxième » ne font pas nécessairement référence à l'ordre chronologique des étapes.

Le complexe avec les première et deuxième couches de matériau électriquement conducteur isolées l'une de l'autre par une couche de matériau isolant comprend en outre au moins un trou de connexion traversant une couche de matériau isolant. Chaque trou de connexion s'étend dans le substrat isolant entre un fond au moins partiellement obturé par la première couche de matériau conducteur et une ouverture débouchant sur une face du substrat. Par exemple, la première couche de matériau conducteur est déposée sur l'une des faces du substrat isolant, lequel avait été préalablement perforé pour former des trous de connexion. La première couche de matériau conducteur vient donc obturer les trous de connexion. La face de cette première couche de matériau conducteur adhérisée et/ou laminée sur le substrat constitue alors le fond des trous de connexion. La première couche de matériau conducteur peut être une grille conductrice (dite « lead frame selon la terminologie anglo-saxonne). L'extrémité opposée d'un trou de connexion, opposée à celle constituant le fond est destinée à rester ouverte pour permettre un passage ultérieur d'un fil de connexion.

Le procédé selon l'invention comprend également la réalisation, par photolithographie et gravure, de motifs sur la deuxième couche de matériau électriquement conducteur. Ces motifs peuvent être par exemple, si des contacts électriques sont gravés dans la première couche de matériau conducteur (constituant donc la face contact d'un circuit double face pour module de carte à puce), des pistes conductrices et/ou une antenne gravée(s) dans la deuxième couche de matériau conducteur.

Le procédé selon l'invention comprend en outre une opération de protection du trou de connexion. Cette opération est nécessaire comme expliqué plus haut pour protéger la première couche de matériau électriquement conducteur pendant la gravure des motifs dans la deuxième couche de matériau électriquement conducteur. Cette protection peut être réalisée de nombreuses manières : enduction d'une résine pour boucher les trous de connexion, dépôt d'un composé photosensible par électrophorèse ou jet d'encre, etc. Dans tous les cas on utilise un matériau soluble de manière à pouvoir l'éliminer ultérieurement pour dégager les trous de connexion et pouvoir les utiliser pour le passage de fils de connexion.

Selon l'invention, la protection du trou de connexion par un matériau soluble est réalisée lors d'une étape préalable à la gravure simultanée de motifs sur la première et la deuxième couche de matériau électriquement conducteur. Ainsi, il est possible de protéger les trous de connexion par un autre matériau que celui du film photosensible définissant les motifs de la deuxième couche de matériau électriquement conducteur. En se libérant de cette contrainte, il devient également possible de traiter la protection des trous de connexion et la réalisation des motifs par des étapes ou successions d'étapes spécifiques. Notamment, au cours de la réalisation des motifs sur la deuxième couche de matériau électriquement conducteur, on peut laisser dégagée une zone d'au moins dix micromètres s autour des trous de connexion, au niveau de la deuxième couche de matériau électriquement conducteur, qui sera dépourvue de matériau électriquement conducteur.

Les fils connectés au fond des trous de connexion n'auront plus de risque de toucher des anneaux conducteurs demeurant autour du bord des trous de connexion.

Selon une première variante ne faisant pas partie de l'invention, les motifs sont réalisés par photolithographie sur la première couche de matériau électriquement conducteur après collage et/ou lamination de la première couche de matériau électriquement conducteur sur le substrat isolant. L'opération de protection du trou de connexion est alors réalisée après la réalisation de motifs sur la deuxième couche de matériau électriquement conducteur. Dans ce cas, les trous de connexion peuvent également être perforés dans le substrat de matériau isolant après la réalisation de motifs sur la deuxième couche de matériau électriquement conducteur et avant de coller et/ou laminer la première couche de matériau électriquement conducteur sur le substrat isolant (dans ce document lorsque le terme « laminer » ou « laminée » est utilisé, ce sera indifféremment en référence à une couche seulement laminée ou collée et laminée).

Selon l'invention, l'opération de protection du trou de connexion est réalisée avant la réalisation de motifs sur la deuxième couche de matériau électriquement conducteur. Des motifs sont alors réalisés au cours des mêmes étapes sur les première et deuxième couches de matériau électriquement conducteur. Le matériau soluble utilisé pour la protection du trou de connexion peut être une résine et une étape de micro-développement peut précéder la réalisation des motifs sur les première et deuxième couches de matériau électriquement conducteur.

Un circuit imprimé est obtenu par le procédé mentionné ci-dessus. Ce circuit imprimé comprend alors un complexe avec
- une première et une deuxième couches de matériau électriquement conducteur, solidaires d'un substrat isolant,
- au moins un trou de connexion s'étendant dans le substrat isolant entre un fond au moins partiellement obturé par la première couche de matériau conducteur et une ouverture débouchant sur une face du substrat, et
- des motifs gravés dans la deuxième couche de matériau électriquement conducteur.

Il comporte en outre une zone d'au moins dix micromètres autour du trou de connexion dépourvue du matériau électriquement conducteur de la deuxième couche de matériau électriquement conducteur.

D'autres caractéristiques et avantages de l'invention apparaîtront à la lecture de la description détaillée et des dessins annexés sur lesquels :
- La figure 1 représente schématiquement en perspective une carte à puce destinée à recevoir un circuit imprimé selon l'invention ;
- Les figures 2A à 2N représentent schématiquement différentes étapes d'un exemple de procédé non-conforme à l'invention;
- les figures 3A à 3I représentent schématiquement différentes étapes d'un autre exemple de procédé non-conforme à l'invention ; et
- les figures 4A à 4F représentent schématiquement différentes étapes d' un exemple de procédé conforme à l'invention.

Plusieurs modes de mise en oeuvre du procédé selon l'invention sont décrits ci-dessous. Tous appartiennent au domaine de la carte à puce.

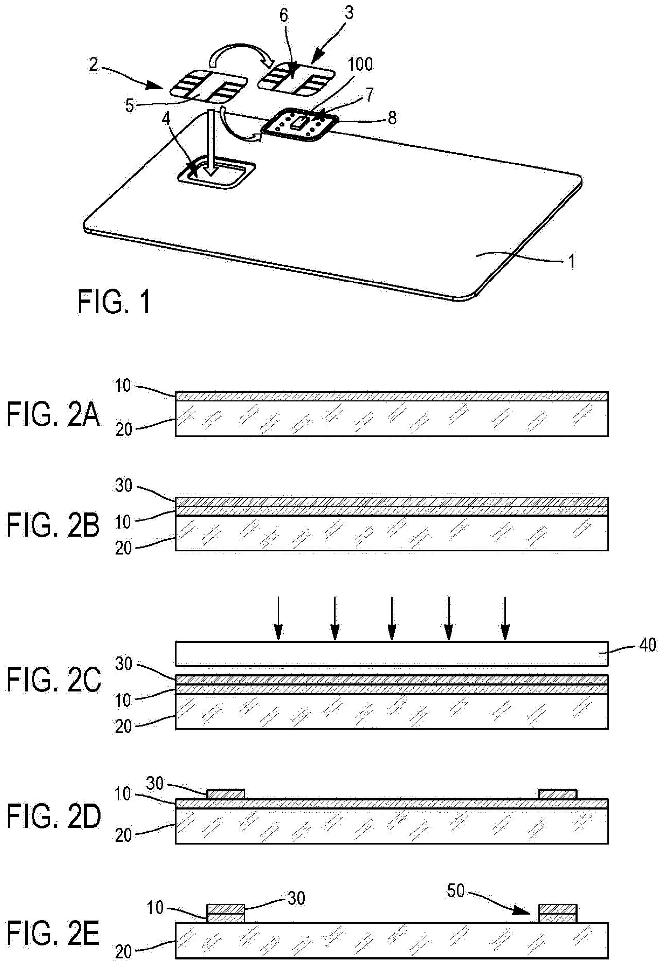

Comme représenté sur la figure 1, une carte à puce 1 comporte un module 2. Un module 2 comprend un circuit imprimé 3 et une puce 100. Le module 2 est généralement réalisé sous forme d'un élément séparé qui est inséré dans une cavité 4 ménagée dans la carte 1.

Le circuit imprimé 3 comporte plusieurs contacts 5 auxquels est connectée la puce 100. Le circuit imprimé 3 est représenté (en haut) vu par sa face avant 6 (face contact). Il est aussi représenté (en bas) vu par sa face arrière 7. Le circuit imprimé 3 représenté correspond à un circuit imprimé double face pour carte « dual », avec des contacts 5 sur la face avant 6 et une antenne 8 sur la face arrière 7.

Les figures 2A à 2N illustrent schématiquement différentes étapes d'un exemple de procédé illustratif ne faisant pas partie de l'invention pour la fabrication du circuit imprimé 3.

Comme représenté sur la figure 2A, on fournit une structure comprenant une couche de matériau électriquement conducteur 10 laminée sur une couche de substrat de matériau électriquement isolant 20. Le matériau électriquement conducteur 10 peut être un métal tel que du cuivre, de l'acier, de l'aluminium ou un alliage de ces métaux. La couche de matériau électriquement conducteur 10 fait par exemple 18µm ou 25µm d'épaisseur. Le matériau isolant 20 peut être un matériau diélectrique de type composite (verre-époxy) ou un matériau plastique (PET, PEN, polyimide, etc.). Le substrat de matériau isolant 20 est généralement mince (son épaisseur est par exemple de l'ordre de 100 µm) pour conserver une flexibilité compatible avec des procédés de fabrication de modules électroniques 3 en continu. L'ensemble constitué du substrat de matériau isolant 20 recouvert de la couche de matériau électriquement conducteur 10 forme un circuit flexible. La couche de matériau conducteur 10 et le substrat de matériau isolant 20 forment un complexe stratifié aussi appelé « copper clad » selon la terminologie anglo-saxonne (si la couche de matériau conducteur 10 est constituée essentiellement de cuivre).

A l'étape suivante, illustrée par la figure 2B, un film ou une couche de résine photosensible 30 est appliqué(e) (lamination ou enduction) en surface de la couche de matériau électriquement conducteur 10.

Ce film de résine photosensible 30 est ensuite insolé à travers un masque 40 (Fig. 2C) puis révélé (Fig. 2D), pour laisser la résine sur les zones de la couche de matériau électriquement conducteur 10 destinées à devenir des motifs 50 (pistes conductrices, antenne, etc.).

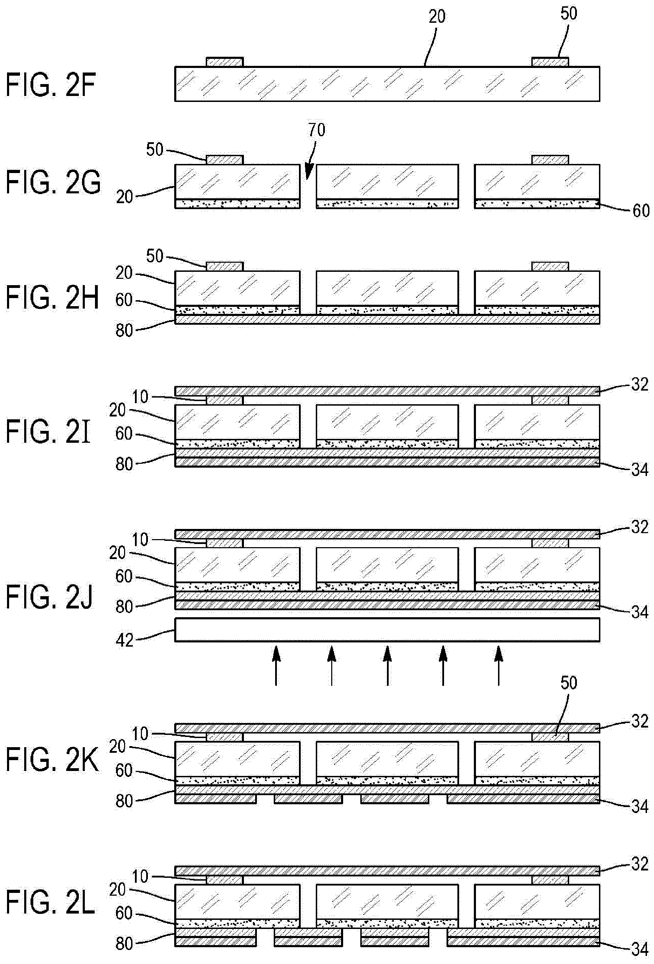

Après gravure (Fig. 2E), le substrat de matériau isolant 20 est à nouveau nu sauf sur les zones destinées à devenir des motifs 50. La résine 30 protectrice est ensuite éliminée pour laisser les motifs 50 à nu (Fig. 2F).

Lors d'une étape non-représentée, une couche de matériau adhésif 60 (dont l'épaisseur est par exemple de l'ordre de 20 µm) est déposée sur la face du substrat de matériau isolant 20 opposée à celle portant les motifs 50.

Des trous de connexion 70 sont ensuite perforés à travers le substrat de matériau isolant 20 et la couche d'adhésif 60 (Fig. 2G). Puis, une autre couche de matériau électriquement conducteur 80 est laminée sur la couche de matériau adhésif 60 (Fig. 2H). Cette nouvelle couche de matériau électriquement conducteur 80 peut être constituée de l'un des matériaux déjà mentionnés plus haut pour former la couche de matériau électriquement conducteur 10 précédente. Comme illustré, les trous de connexion 70 sont recouverts et obturés à l'une de leurs extrémités, par la nouvelle couche de matériau électriquement conducteur 80.

A l'étape illustrée par la figure 2I, deux films de résine photosensible 32, 34 sont chacun respectivement appliqués (par enduction ou lamination) sur une face du complexe constitué des deux couches de matériau électriquement conducteur 10, 80 et du substrat de matériau isolant 20.

L'un 34 des deux films de résine photosensible 32, 34 est ensuite insolé à travers un masque 42 (Fig. 2J) puis révélé (Fig. 2K), pour laisser la résine sur les zones de la couche de matériau électriquement conducteur 80 destinées à devenir des motifs 50 (pistes conductrices, antenne, etc.).

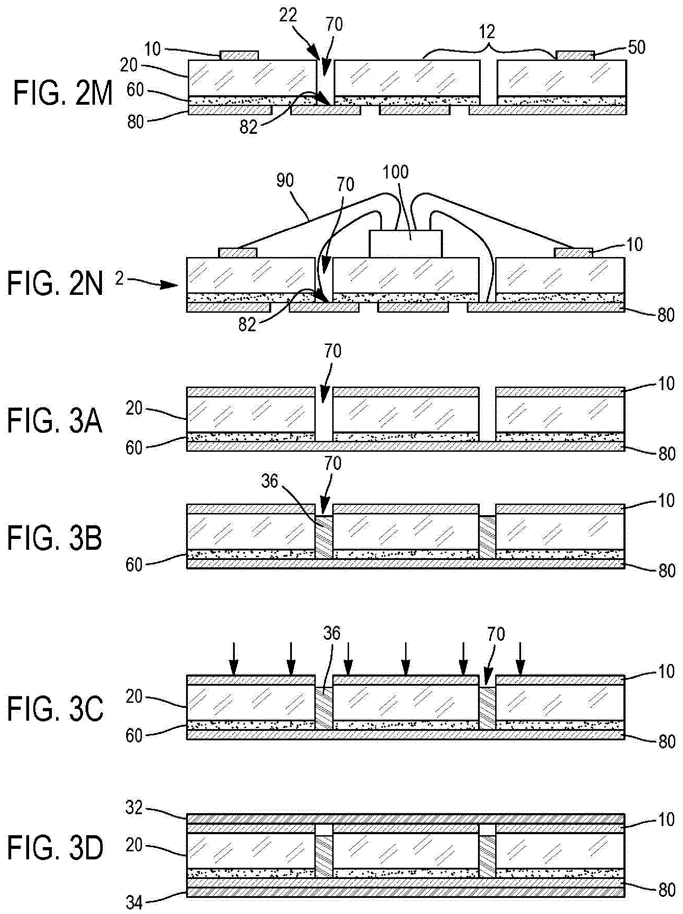

Après gravure (Fig. 2L) et suppression des deux films de résine photosensible 32, 34 (Fig. 2M), on obtient un circuit imprimé comprenant un complexe avec
- une première 80 et une deuxième 10 couches de matériau électriquement conducteur, solidaires d'un substrat isolant 20,
- au moins un trou de connexion 70 s'étendant dans le substrat isolant 20 entre un fond 82 au moins partiellement obturé par la première couche de matériau conducteur 80 et une ouverture 22 débouchant sur une face du substrat isolant 20, et
- des motifs 50 gravés dans la deuxième couche de matériau électriquement conducteur 10.

Le complexe comporte une zone 12 d'au moins dix micromètres autour du trou de connexion 70 dépourvue du matériau électriquement conducteur de la deuxième couche 10 de matériau électriquement conducteur.

Ce complexe peut être utilisé pour réaliser un module 2 (Fig. 2N), dans lequel des fils de connexion 90 sont soudés au fond 82 des trous de connexion 70, par l'une de leurs extrémités, à la face arrière de la première couche de matériau électriquement conducteur 80, tandis que l'autre extrémité est soudée à la puce 100.

Les figures 3A à 3I illustrent schématiquement différentes étapes d'un autre exemple de procédé illustratif ne faisant pas partie de l'invention pour la fabrication du circuit imprimé 3.

Comme représenté sur la figure 3A, on fournit une structure comprenant deux couches 10, 80 de matériau électriquement conducteur laminées sur un substrat de matériau électriquement isolant 20. La nature et les épaisseurs des matériaux électriquement conducteurs et électriquement isolants peuvent être semblables à celles des matériaux mentionnés en relation avec le mode de mise en oeuvre du procédé précédent. La structure de la figure 3A est sensiblement la même que celle de la figure 2H. La différence tient essentiellement au fait que la deuxième couche de matériau électriquement conducteur 10 ne comporte pas encore les motifs 50.

A l'étape suivante, illustrée par la figure 3B, les trous de connexion 70 sont protégés par une résine 36. Cette résine 36 peut être dispensée ou déposée dans les trous de connexion 70 par enduction, jet d'encre ou électrophorèse. Cette résine 36 est résistante aux bains de gravure habituellement utilisés pour la fabrication des circuits imprimés. Elle peut être photosensible ou non.

La résine photosensible 36 peut subir ensuite un micro-développement (3C).

En effet, selon la méthode de dépôt de la résine 36 dans les trous de connexion 70, une faible épaisseur peut rester sur la surface de la deuxième couche de matériau électriquement conducteur 10. Ce dépôt résiduel est enlevé par une étape de micro-développement qui laisse la surface de la deuxième couche de matériau électriquement conducteur 10 propre. La nature de ce micro-développement dépend de la résine 36. Elle peut être chimique par exemple.

A l'étape illustrée par la figure 3D, deux films de résine photosensible 32, 34 sont chacun respectivement appliqués sur une face du complexe constitué des deux couches de matériau électriquement conducteur 10, 80 et du substrat de matériau isolant 20.

La résine 36 ne doit pas être soluble dans les bains de développement des résines 32, 34.

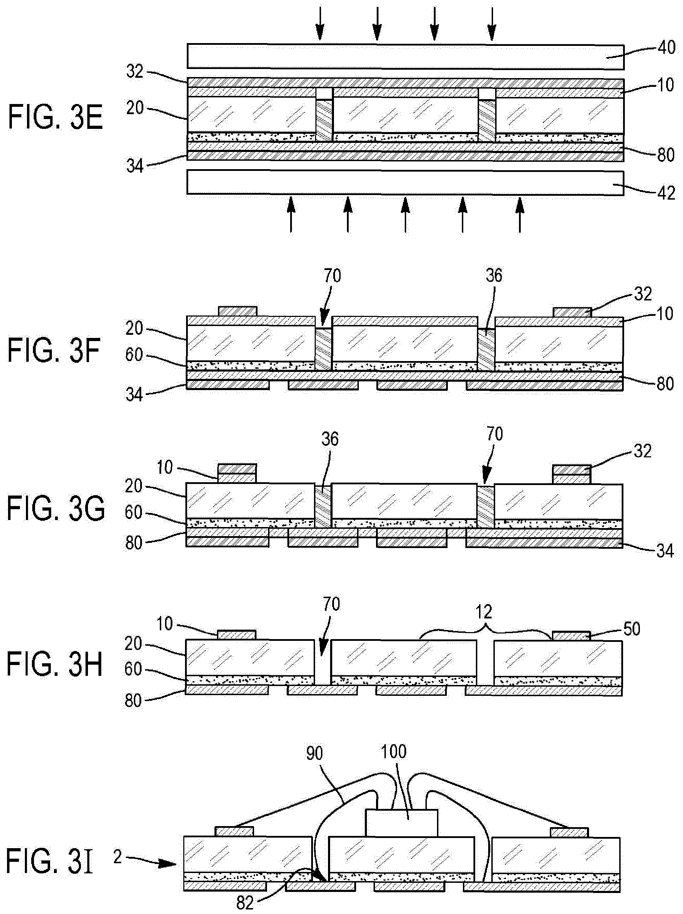

Les deux films de résine photosensible 32, 34 sont ensuite insolés à travers des masques 40, 42 (Fig. 3E), puis révélés (Fig. 3F), pour laisser de la résine 32, 34 sur les zones des couches de matériau électriquement conducteur 10, 80 de matériau électriquement conducteur destinées à devenir des motifs 50 (contacts, pistes conductrices, antenne, etc.).

Après gravure (Fig. 3G) et suppression des deux films de résine photosensible 32, 34 et de la résine 36 (Fig. 3H), on obtient un circuit imprimé comprenant un complexe identique à celui de la figure 2M.

Comme précédemment, ce complexe peut être utilisé pour réaliser un module 2 (Fig. 3I) semblable à celui de la figure 2N.

En variante, la résine photosensible 36 est appliquée par électrophorèse sur toutes les faces conductrices. Il y a donc de la résine 36 dans les trous et sur chacune des faces des première 80 et deuxième 10 couches de matériau conducteur. Une étape de micro-développement permet de retirer la résine 36 sur la face de la deuxième 10 couche de matériau conducteur. Par contre, il reste de la résine 36 sur la première 80 couche de matériau conducteur. Un film ou une résine de polarité inverse à la résine 36 (négative ou positive) est alors appliquée sur la surface de la deuxième couche 10 de matériau électriquement conducteur. Puis les étapes 3E et suivantes sont mises en oeuvre.

Le module 2 obtenu par l'un ou l'autre des modes de mise en oeuvre présentés ci-dessus est compatible avec les procédés et techniques usuels d'assemblage en continu des modules pour cartes à puce (fixage de puce - die-attach selon la terminologie anglo-saxonne, soudure de fils - « wire-bonding » selon la terminologie anglo-saxonne, encapsulation UV ou thermique) et avec les procédés usuels d'encartage des modules dans les corps de cartes.

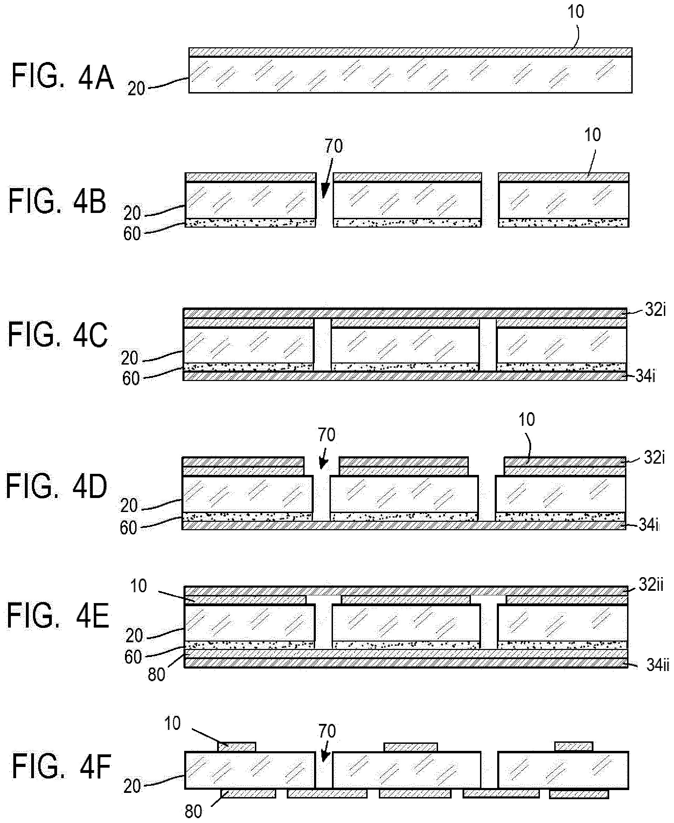

Les figures 4A à 4F illustrent schématiquement différentes étapes d'un exemple de procédé selon l'invention pour la fabrication du circuit imprimé 3.

Comme représenté sur la figure 4A, on fournit une structure comprenant une couche 10 de matériau électriquement conducteur laminée sur un substrat de matériau électriquement isolant 20. La nature et les épaisseurs des matériaux électriquement conducteurs peuvent être semblables à celles des matériaux mentionnés en relation avec les modes de mise en oeuvre précédemment décrits. La face du substrat de matériau électriquement isolant 20 opposée à celle comportant la couche 10 de matériau électriquement conducteur reçoit ensuite une couche d'adhésif 60.

A l'étape suivante, illustrée par la figure 4B, des trous de connexion 70 sont réalisés, par exemple par perforation, sur l'ensemble de l'épaisseur de la structure précédente. Deux films, respectivement 32i et 34i sont ensuite disposés (par exemple par enduction ou lamination) sur la couche conductrice 10 d'une part et sur la couche de matériau adhésif 60 d'autre part (voir figure 4C). Le film 32i est un film de résine photosensible. Le film 34i est un film protecteur de la couche d'adhésif 60. Il peut s'agir d'une résine photosensible ou non.

Une succession d'étapes non-représentées (insolation et révélation du film photosensible 32i et gravure chimique de la couche conductrice 10 selon les motifs révélés dans le film de résine photosensible 32i) est ensuite réalisée de manière à mettre à nu le substrat isolant 20, sur au moins 10µm autour des puits de connexion 70. Par exemple, les zones ainsi mises à nu correspondent à des anneaux (voir figure 4D).

Les films 32i, 34i sont ensuite éliminés (par exemple le film de résine photosensible 32i est dissous, tandis que le film 34i est pelé). Puis, une deuxième couche conductrice 80 est laminée sur la face du substrat isolant 20 opposée à celle sur laquelle la périphérie des trous de connexion a été dégagée du matériau conducteur.

Deux autres films de résine photosensible 32ii, 34ii sont chacun respectivement appliqués (par enduction ou lamination) sur une couche conductrice 10, 80 (voir figure 4E).

Les deux faces subissent alors, simultanément, des étapes d'insolation, et de révélation des films photosensibles 32ii, 34 et de gravure chimique des couches conductrices 10, 80 selon les motifs souhaités pour chacune des faces. Les films photosensibles 32ii, 34ii sont ensuite dissous et la structure obtenue est sensiblement équivalente aux complexes déjà décrits en relation avec figures 2M et 3H.

Comme précédemment, ce complexe peut être utilisé pour réaliser un module 2 semblable à celui de la figure 2N.

## Revendications

1. Procédé de fabrication d'un circuit imprimé (3) pour module électronique de carte à puce comprenant
- la réalisation d'un complexe comprenant une première (80) et une deuxième (10) couches de matériau électriquement conducteur, solidaires d'un substrat isolant (20) et les isolant l'une de l'autre, et comprenant en outre au moins un trou de connexion (70) s'étendant dans le substrat isolant (20) entre un fond (82) au moins partiellement obturé par la première couche (80) de matériau conducteur et une ouverture (22) débouchant sur une face du substrat isolant (20), et
- la réalisation par photolithographie et gravure de motifs (50) sur la deuxième couche (10) de matériau électriquement conducteur,
**caractérisé par le fait qu'**il comprend en outre une opération de protection du trou de connexion (70) avec un matériau soluble (32ii, 34ii), réalisée préalablement à une étape de gravure simultanée de motifs (50) sur la première (80) et la deuxième couche (10) de matériau électriquement conducteur et **par le fait que** la gravure des motifs (50) sur la deuxième couche (10) de matériau électriquement conducteur est réalisée après une étape de gravure ayant laissé une zone (12) d'au moins dix micromètres autour du trou de connexion (70) dépourvue du matériau électriquement conducteur de la deuxième couche (10) de matériau électriquement conducteur.

2. Procédé selon la revendication 1, dans lequel le trou de connexion (70) est réalisé par perforation du substrat isolant (20) avant la réalisation de motifs (50) sur la deuxième couche (10) de matériau électriquement conducteur.

3. Procédé selon la revendication 1 ou 2, dans lequel la première couche (80) de matériau électriquement conducteur est laminée sur le substrat isolant (20) après la réalisation du trou de connexion (70) par perforation du substrat isolant (20).

4. Procédé selon la revendication 3, dans lequel des motifs (50) sont réalisés par photolithographie sur la première couche (80) de matériau électriquement conducteur après lamination de la première couche (80) de matériau électriquement conducteur sur le substrat isolant (20) et donc après perforation du trou de connexion (70).

5. Procédé selon l'une des revendications précédentes, dans lequel le matériau soluble (32ii, 34ii) est une résine.

6. Procédé selon la revendication 5, dans lequel une étape de micro-développement précède la réalisation des motifs (50) sur la première (80) et la deuxième (10) couches de matériau électriquement conducteur.

## Patentansprüche

1. Verfahren zur Herstellung einer gedruckten Schaltung (3) für ein elektronisches Modul einer Chipkarte, das Folgendes umfasst
- Herstellung eines Komplexes mit einer ersten (80) und einer zweiten (10) Schicht aus elektrisch leitendem Material, die mit einem isolierenden Substrat (20) fest verbunden sind und sie voneinander isolieren, und außerdem mit mindestens einem Verbindungsloch (70), das sich in dem isolierenden Substrat (20) zwischen einem Boden (82), der zumindest teilweise von der ersten Schicht (80) aus leitendem Material verschlossen wird, und einer Öffnung (22), die in eine Seite des isolierenden Substrats (20) mündet, erstreckt, und
- das Herstellen von Mustern (50) auf der zweiten Schicht (10) aus elektrisch leitfähigem Material durch Fotolithografie und Ätzen,
**dadurch gekennzeichnet, dass** es außerdem einen Schritt des Schützens des Verbindungslochs (70) mit einem löslichen Material (32ii, 34ii) umfasst, der vor einem Schritt des gleichzeitigen Ätzens von Mustern (50) auf der ersten (80) und der zweiten Schicht (10) aus elektrisch leitfähigem Material durchgeführt wird, und dadurch, dass das Ätzen der Muster (50) auf der zweiten Schicht (10) aus elektrisch leitfähigem Material nach einem Ätzschritt durchgeführt wird, der eine Zone (12) von mindestens zehn Mikrometern um das Verbindungsloch (70) herum frei von dem elektrisch leitfähigen Material der zweiten Schicht (10) aus elektrisch leitfähigem Material gelassen hat.

2. Verfahren nach Anspruch 1, bei dem das Verbindungsloch (70) durch Perforieren des isolierenden Substrats (20) vor der Herstellung von Mustern (50) auf der zweiten Schicht (10) aus elektrisch leitfähigem Material hergestellt wird.

3. Verfahren nach Anspruch 1 oder 2, bei dem die erste Schicht (80) aus elektrisch leitendem Material auf das isolierende Substrat (20) laminiert wird, nachdem das Verbindungsloch (70) durch Perforieren des isolierenden Substrats (20) hergestellt wurde.

4. Verfahren nach Anspruch 3, wobei Muster (50) durch Fotolithografie auf der ersten Schicht (80) aus elektrisch leitfähigem Material nach dem Laminieren der ersten Schicht (80) aus elektrisch leitfähigem Material auf das isolierende Substrat (20) und somit nach dem Perforieren des Verbindungslochs (70) hergestellt werden.

5. Verfahren nach einem der vorhergehenden Ansprüche, wobei das lösliche Material (32ii, 34ii) ein Harz ist.

6. Verfahren nach Anspruch 5, bei dem ein Mikroentwicklungsschritt der Herstellung der Muster (50) auf der ersten (80) und der zweiten (10) Schicht aus elektrisch leitfähigem Material vorausgeht.

## Claims

1. A method of manufacturing a printed circuit board (3) for an electronic chip card module comprising
- the production of a complex comprising a first (80) and a second (10) layer of electrically conductive material, integral with an insulating substrate (20) and insulating them from each other, and further comprising at least one connection hole (70) extending into the insulating substrate (20) between a bottom (82) at least partially closed by the first layer (80) of conductive material and an opening (22) opening onto one face of the insulating substrate (20), and
- photolithographing and etching patterns (50) on the second layer (10) of electrically conductive material,
**characterized in that** it further comprises an operation of protecting the connection hole (70) with a soluble material (32ii, 34ii), carried out prior to a step of simultaneous etching of patterns (50) on the first (80) and second (10) layers of electrically conductive material and by the fact that the etching of the patterns (50) on the second layer (10) of electrically conductive material is carried out after an etching step which has left an area (12) of at least ten micrometres around the connection hole (70) free of the electrically conductive material of the second layer (10) of electrically conductive material.

2. A method according to claim 1, wherein the connection hole (70) is made by perforating the insulating substrate (20) prior to patterning (50) the second layer (10) of electrically conductive material.

3. A method according to claim 1 or 2, wherein the first layer (80) of electrically conductive material is laminated to the insulating substrate (20) after the connection hole (70) has been made by perforating the insulating substrate (20).

4. A method according to claim 3, wherein patterns (50) are made by photolithography on the first layer (80) of electrically conductive material after lamination of the first layer (80) of electrically conductive material onto the insulating substrate (20) and thus after perforation of the connection hole (70).

5. A method according to any of the preceding claims, wherein the soluble material (32ii, 34ii) is a resin.

6. A method according to claim 5, wherein a micro-development step precedes the making of the patterns (50) on the first (80) and second (10) layers of electrically conductive material.
